# EUROPÄISCHE PATENTSCHRIFT

(11) **EP 2 841 953 B1**
(45) Veröffentlichungstag und Bekanntmachung des Hinweises auf die Patenterteilung: **08.06.2016**
(21) Anmeldenummer: 13717013.0
(22) Anmeldetag: 11.04.2013
(51) Int. Cl.: G01R 13/02, G01R 19/25, G01R 1/04, G01R 1/067

(54) **ELEKTRISCHES MESSGERÄT MIT EINER UMLAUFENDEN ANZEIGE**
ELECTRIC MEASURING DEVICE WITH A CIRCUMFERENTIAL DISPLAY
INSTRUMENT DE MESURE ÉLECTRIQUE COMPRENANT UN AFFICHAGE CIRCOMFÉRENTIEL

(30) Priorität: 24.04.2012 DE 102012206735
(43) Veröffentlichungstag der Anmeldung: 04.03.2015
(73) Patentinhaber: Testo AG, 79853 Lenzkirch (DE)
(72) Erfinder: KAISER, Carolin, CH-9493 Mauren (CH); ANDRESEN, Michael, 78112 St. Georgen (DE); EMBERGER, Holger-Max, 79211 Denzlingen (DE)
(74) Vertreter: Börjes-Pestalozza, Henrich
(86) Internationale Anmeldenummer: PCT/EP2013/057621
(87) Internationale Veröffentlichungsnummer: WO 2013/160118

(56) Entgegenhaltungen:
- US-A1- 2005 184 722

## Beschreibung

Die Erfindung betrifft ein Messgerät zum Erfassen und Anzeigen von elektrischen Größen, insbesondere zum Erfassen und Anzeigen von Spannungs-, Strom- und/oder Widerstandswerten.

Elektrische Messgeräte werden beispielsweise zur Installation und Wartung von elektrischen Leitungen, zum Anschluss von Motoren oder einer Verdrahtung von Schaltschränken verwendet. Dabei muss eine Bedienperson oft in ungünstigen Positionen arbeiten, z.B. über Kopf und/oder in beengten Räumen. Die Anzeige eines Messgerätes ist typischerweise auf der Vorderseite der Geräte angebracht, so dass sie von der betreffenden Bedienperson nur von vorne abgelesen werden kann. Dies bedeutet, dass das Messgerät zum Gesichtsfeld des Nutzers gedreht werden muss. In ungünstigen Arbeitspositionen kann ein derartiges Drehen des Messgerätes jedoch sehr schwierig oder sogar unmöglich sein. Dann muss sich die Bedienperson auf eine eventuell vorhandene und typischerweise wesentlich ungenauere akustische Anzeige und/oder einen nur sehr ungenau abgelesenen Messwert verlassen.

Falsch abgelesene Werte können jedoch zu einer Fehleinschätzung hinsichtlich des Pegels des erfassten Messwertes und unter Umständen zu einer Gefährdung der Bedienperson beispielsweise durch eine Hochspannung führen. Ein Drehen des Messgerätes in ungünstige Arbeitspositionen kann wiederum zu gefährlichen Situationen wie beispielsweise einem Sturz von einer Leiter führen. In der täglichen Praxis bedeutet dies, dass die betreffende Bedienperson eine ungenauer oder überhaupt keine Kenntnis von den eigentlich gewünschten Messwerten, beispielsweise die anliegende Spannung und/oder der fließende Strom, erlangt. Damit ist also nicht nur die Zuverlässigkeit der Informationsübermittlung bzgl. der erfassten Messwerte von der Anzeige eines Messgerätes an die das Messgerät nutzende Bedienperson beeinträchtigt, vielmehr ist in vielen Fällen auch die Arbeitssicherheit der Bedienperson reduziert.

Aus US 2005/0184722 A1 ist eine Strommesszange mit dualen Display bekannt, bei welcher ein Digitaldisplay an einer Grundfläche des Messgeräts ausgebildet und mit einer Verschlusslappe abdeckbar ist.

Der vorliegenden Erfindung liegt die Aufgabe zugrunde, die Zuverlässigkeit der Informationsübermittlung zwischen der Anzeige eines elektrischen Messgerätes und einer das Messgerät nutzenden Bedienperson zu verbessern.

Diese Aufgabe wird gelöst durch den Gegenstand des unabhängigen Patentanspruchs 1. Vorteilehafte Ausführungsformen der vorliegenden Erfindung sind in den abhängigen Ansprüchen beschrieben.

Gemäß einem ersten Aspekt der Erfindung wird ein Messgerät zum Erfassen und Anzeigen von elektrischen Größen, insbesondere zum Erfassen und Anzeigen von Spannungs-, Strom- und/oder Widerstandswerten beschrieben. Das beschriebene Messgerät weist auf (a) ein Gehäuse, (b) eine Messeinrichtung, welche in dem Gehäuse angeordnet ist, (c) zumindest eine Prüfelektrode und/oder zumindest einen Anschluss für zumindest eine Prüfelektrode, welche bzw. welcher elektrisch leitend mit der Messeinrichtung verbunden ist, (d) eine Anzeigeeinrichtung, welche an dem Gehäuse angebracht ist und welche mit der Messeinrichtung gekoppelt ist, so dass eine von der Messeinrichtung erlangte Messinformation anzeigbar ist. Erfindungsgemäß erstreckt sich die Anzeigeeinrichtung über eine Kante des Gehäuses, so dass die Anzeigeeinrichtung sowohl zumindest einen ersten Teil einer ersten Außenseite des Gehäuses als auch zumindest einen zweiten Teil einer zweiten Außenseite des Gehäuses bedeckt, wobei die erste Außenseite und die zweite Außenseite winklig, insbesondere senkrecht, zueinander orientiert sind.

Dem beschriebenen Messgerät liegt die Erkenntnis zugrunde, dass die Anzeigeeinrichtung im Vergleich zu einer herkömmlichen Anzeigeeirichtung nicht nur von einer Seite sondern von mehreren Seiten betrachtet und dabei die angezeigte Information zuverlässig erkannt werden kann. Auf alle Fälle vergrößert sich im Vergleich zu bekannten ebenen oder planaren Anzeigen oder Displays der Bereich für mögliche Beobachtungswinkel, unter dem die Anzeigeeinrichtung auf bequeme Weise von einer Bedienperson betrachtet werden kann. Der Winkel, unter dem die beschriebene Anzeigeeinrichtung von einer Bedienperson betrachtet werden kann, beträgt im Gegensatz zu einer bekannten ebenen oder planaren Anzeige mehr als 180°. Falls die Anzeigeeinrichtung einen (abgerundeten) Knick oder eine Rundung um 90° aufweist, dann kann der maximale Winkelbereich, unter dem die Anzeigeeinrichtung von einer Bedienperson erkannt werden kann, bis zu maximal ausschließlich 270° betragen, wobei in den Randbereichern dieses Winkelbereichs der jeweilige Teil der Anzeigeeinrichtung von einer Bedienperson nur unter einem sehr flachen Winkel und damit nur sehr schlecht betrachtet werden kann.

Die Kante des Gehäuses kann eine eckige oder eine abgerundete Kante sein. In entsprechender Weise kann die Anzeigeeirichtung eine eher eckige oder eine eher abgerundete Form aufweisen. Die Kante kann auch eine kontinuierliche Rundung sein, welche die beiden Außenseiten miteinander verbindet.

Aufgrund der abgewinkelten Form der Anzeigeeinrichtung kann diese auch als umlaufende Anzeige oder als Rundumdisplay bezeichnet werden. Wie bereits oben erwähnt, kann die abgewinkelte Form auch mittels einer Rundung realisiert sein, welche sich ausgehend von der ersten Außenseite in die zweite Außenseite erstreckt. Dabei kann sich die Rundung über die gesamte Anzeigeeinrichtung erstrecken oder die Rundung kann an zumindest einer der beiden Außenseiten in eine zumindest annähernd planare Fläche übergehen.

Das Messgerät kann jedes beliebiges Gerät sein, welches in der Lage ist, elektrische Größen zu erfassen und einer Bedienperson eine optische Information über bestimmte Eigenschaften der erfassten elektrischen Messgröße bereitzustellen. Die optische Information kann dabei in Form eines Messwertes übermittelt werden, welcher mittels einer digitalen oder analogen Darstellung angezeigt wird. Dabei kann insbesondere eine LCD (Liquid Crystal Display) Anzeigetechnik verwendet werden. Die optische Information kann auch mittels eines Leuchtelements oder mittels mehrerer Leuchtelemente realisiert werden, wobei jedem Leuchtelement ein bestimmter Wertebereich für die erfasste elektrische Größe zugeordnet ist. Das Leuchtelement bzw. die Leuchtelemente können beispielsweise mittels einer bzw. mittels mehrerer Leuchtdioden realisiert werden.

Das Messgerät kann beispielsweise ein Spannungsprüfer, ein sog. Multimeter, eine Stromzange oder eine Drehfeldrichtungsanzeigevorrichtung sein. Diese Aufzählung ist nicht abschließend, so dass auch beliebige andere Messgeräte mit der beschriebenen sich über zumindest zwei Außenseiten erstreckenden Anzeigeeinrichtung ausgestattet werden können.

Das Messgerät kann auch ein sog. Testgerät sein, mit dem die Funktionalität einer elektrischen oder elektronischen Vorrichtung überprüft und das Prüfergebnis einer Bedienperson mittels einer vordefinierten Anzeige-Logik mitgeteilt wird. Dabei kann beispielsweise das Aufleuchten eines bestimmten Leuchtelements, beispielsweise eine Leuchtdiode, eine korrekte Funktionalität einer Komponente und/oder einer Funktion der getesteten elektrischen oder elektronischen Vorrichtung anzeigen.

Der Anschluss für die Prüfelektrode kann ein von außen zugänglicher Anschluss für ein Messkabel sein, an dem wiederum eine Prüfelektrode angebracht oder anschließbar ist. Alternativ kann der Anschluss auch ein interner von außen nicht zugänglicher Anschluss insbesondere im inneren des Gehäuses sein, wobei in diesem Fall die Prüfelektrode bevorzugt nicht lösbar an dem Gehäuse des beschriebenen Messgerätes angeordnet ist.

Die Prüfelektrode kann abhängig von den jeweiligen Rahmenbedingungen, insbesondere von der räumlichen Zugänglichkeit eines Kontaktpunkts, eine geeignete Form aufweisen. Eine Prüfelektrode kann ausreichend sein, wenn beispielsweise wie bei einem einpoligen Spannungsprüfer oder Phasenprüfer ein Strompfad (für eine extrem kleine Stromstärke) von der mit einem Erdungspotential gekoppelten Bedienperson bereitgestellt wird. Bevorzugt weist das beschriebene Messgerät neben der oben genannten Prüfelektrode zumindest noch eine weitere Prüfelektrode auf, welche ebenfalls in bekannter Weise mit der Messeinrichtung gekoppelt ist.

Anschaulich ausgedrückt ist das beschriebene Messgerät, welches auch ein Testgerät sein kann, mit einem Display oder einer Anzeigeeinrichtung ausgestattet, welche von mehreren Seiten und damit unter einem großen Winkelbereich abgelesen werden kann. Ein Drehen oder Verdrehen des Messgerätes ist somit nicht mehr erforderlich, um einer Bedienperson ein zuverlässiges und bequemes Ablesen der auf dem Display angezeigten Information(en) zu ermöglichen. Die Bedienperson kann also ohne eine Beeinträchtigung ihrer Arbeitssicherheit gefahrlos aus ihrer aktuellen Arbeitsposition heraus den auf dem Display angezeigten Messwert oder die auf dem Display angezeigte Information ablesen. Damit werden verschiedene individuellen Arbeitsweisen von einer oder von mehreren Bedienpersonen unterstützt, so dass in der täglichen Praxis mit einer hohen Akzeptanz des in diesem Dokument beschriebenen elektrischen Messgerätes zu rechnen ist.

Zusammenfassend bestehen die wichtigsten Vorteile des beschriebenen mit einem Rundumdisplay ausgestatteten Messgerätes darin, die Arbeit für eine Bedienperson einfacher zu gestalten und die Arbeitssicherheit der Bedienperson durch stets zugängliche Informationen zu verbessern.

Gemäß einem Ausführungsbeispiel der Erfindung ist die Anzeigeeinrichtung konfiguriert zumindest eine erste Messinformation in einem ersten Teilbereich der Anzeigeeinrichtung und zumindest eine zweite Messinformation in einem zweiten Teilbereich der Anzeigeeinrichtung anzuzeigen. Dabei befindet sich der erste Teilbereich an lediglich einer der beiden Außenseiten befindet und der zweite Teilbereich erstreckt sich von der ersten Außenseite über die Kante des Gehäuses in die zweite Außenseite.

Der erste Teilbereich der Anzeigeeinrichtung kann dabei insbesondere ein zumindest annähernd ebener, planer oder planarer Teilbereich sein, wohingegen der zweite Teilbereich der Anzeigeeinrichtung gewinkelt oder zumindest gebogen um die Kante zwischen den beiden Außenseiten des Gehäuses herum verläuft.

Anschaulich gesprochen bedeutet dies, dass die an dem ersten Teilbereich angezeigte erste Messinformation genauso wie die Messinformationen, die von einem herkömmlichen Messgerät mit lediglich einem planaren Display angezeigt werden können, lediglich unter einem relativ kleinen Blickwinkelbereich von einer Bedienperson abgelesen werden kann. Im Gegensatz dazu kann die zweite Messinformation unter einem erweiterten Blickwinkelbereich zuverlässig von einer das beschriebene Messgerät nutzenden Bedienperson abgelesen werden.

Die beschriebene Aufteilung der gesamten von der Anzeigevorrichtung anzeigbaren Informationen in erste und zweite Messinformationen hat den Vorteil, dass dann, wenn nicht sämtliche Messinformationen in dem hinsichtlich seiner anzeigbaren Informationsmenge begrenzten zweiten Teilbereich angezeigt werden können, lediglich die besonders wichtigen Informationen in dem zweiten Teilbereich angezeigt werden, wohingegen die weniger wichtigen oder auch sämtliche Messinformationen in dem ersten planaren Teilbereich angezeigt werden.

Gemäß einem weiteren Ausführungsbeispiel der Erfindung weist die zweite Messinformation eine digitale Ja/Nein-Information über eine vorgegebene elektrische Eigenschaft des von der zumindest einen Prüfelektrode erfassten Signals auf.

Die digitale Ja/Nein-Information kann zum Beispiel das Vorhandensein einer Gefährdungsmöglichkeit anzeigen. So kann beispielsweise ein sich über die Kante des Gehäuses erstreckendes Flächenelement des zweiten Teilbereichs aufleuchten, wenn die an der Prüfelektrode anliegende Spannung einen vorgegebenen für den Menschen gefährlichen Spannungspegel überschreitet.

Die digitale Ja/Nein-Information kann auch dazu verwendet werden, bei einem zumindest zweipoligen Messgerät anzuzeigen, ob sich zwischen den dann zwei Prüfelektroden des Messgeräts eine elektrisch durchgängige Leitung befindet. Ferner kann die digitale Ja/Nein-Information auch beispielsweise dazu verwendet werden, die Drehrichtung eines elektrischen Drehfeldes oder das Überschreiten eines bestimmten Stromwertes anzuzeigen, wobei letzteres insbesondere dann sinnvoll erscheint, wenn es sich bei dem beschriebenen Messgerät um eine sog. Stromzange handelt.

Gemäß einem weiteren Ausführungsbeispiel der Erfindung weist die zweite Messinformation zusätzlich zumindest eine weitere digitale Ja/Nein-Information über eine vorgegebene weitere elektrische Eigenschaft des von der zumindest einen Prüfelektrode erfassten Signals auf.

Die weitere digitale Ja/Nein-Information kann beispielsweise mittels eines weiteren Flächenelements angezeigt werden, welches sich ebenfalls über die Kante des Gehäuses erstreckt und welches dann aufleuchtet, wenn das von der zumindest einen Prüfelektrode erfasste Signal die vorgegebene weitere elektrische Eigenschaft aufweist. So kann beispielsweise eine Mehrzahl von leuchtfähigen Flächenelementen dazu verwendet werden, eine Bedienperson darüber zu informieren, wenn sich ein Pegelwert des von der zumindest einen Prüfelektrode erfassten Signals größer als vorbestimmte Referenzpegel ist.

Anders ausgedrückt kann dies bedeuten, dass der zweite Teilbereich mehrere zum Aufleuchten fähige Flächenelemente aufweisen kann, wobei jedem Flächenelement ein bestimmter Referenzwert zugeordnet ist. Sollte der Pegel des von der Prüfelektrode erfassten Signals einen bestimmten dieser Referenzwerte überschreiten, dann kann die Messeinrichtung und/oder die Anzeigeeinrichtung derart konfiguriert sein, dass nicht nur das betreffende diesem bestimmten Referenzwert zugeordnete Flächenelement sondern auch diejenigen Flächenelemente aufleuchten, welche kleineren und ebenfalls überschrittenen anderen Referenzwerten zugeordnet sind.

Die Referenzwerte können insbesondere Spannungs- oder Stromreferenzwerte sein.

Gemäß einem weiteren Ausführungsbeispiel der Erfindung ist die erste Messinformation eine quantitative Information über das von der zumindest einen Prüfelektrode erfasste Signal.

Die quantitative Information kann beispielsweise ein Spannungspegel in der Einheit Volt [V] oder eine Stromwert in Ampere [A] sein, welche auf beliebige Weise angezeigt werden können. So kann die Anzeige der ersten Messinformation analog über einen drehbaren Zeiger oder einen verschiebbaren Pegelstrich angezeigt werden, wobei der Zeiger oder der Pegelstrich auch digital in beispielsweise in einem LCD Display dargestellt werden können. Ebenfalls kann die erste Messinformation auch in Form eines alphanumerischen Zeichens angezeigt werden, wobei das alphanumerische Zeichen Zahlen, Buchstaben und/oder Sonderzeichen wie beispielsweise einen Punkt oder ein Komma aufweisen kann.

Es wird darauf hingewiesen, dass selbstverständlich auch andere Einheiten wie beispielsweise die Einheiten mV, mA, µV (Mikrovolt), µA (Mikroamper), MV oder MA verwendet werden können, um einen Spannungspegel oder einen Strompegel anzuzeigen.

Gemäß einem weiteren Ausführungsbeispiel der Erfindung erstreckt sich die Anzeigeeinrichtung über zumindest eine weitere Kante des Gehäuses, so dass die Anzeigeeinrichtung zusätzlich einen dritten Teil einer dritten Außenseite des Gehäuses bedeckt, wobei die zweite Außenseite und die dritte Außenseite winklig, insbesondere senkrecht, zueinander orientiert sind. Dies hat den Vorteil, dass der Blickwinkelbereich, unter dem die Anzeigeeinrichtung von einer das beschriebene Messgerät nutzenden Bedienperson betrachtet werden kann, noch größer ist. Dadurch wird die Bedienerfreundlichkeit des beschriebenen Messgeräts noch weiter erhöht.

Die dritte Außenseite kann beispielsweise zumindest annähernd parallel zu der ersten Außenseite orientiert sein. Dies bedeutet, dass die erste Außenseite und die zweite Außenseite einander gegenüberliegende Außenseiten des Gehäuses darstellen.

Gemäß einem weiteren Ausführungsbeispiel der Erfindung weist die Anzeigeeinrichtung einen Lichtleiter auf, der um die Kante des Gehäuses herum geführt ist. Dies hat den Vorteil, dass die Rundumanzeige / Anzeigeeinrichtung auf besonders einfache Weise mit (jeweils) einem einzigen optischen Leuchtelement realisiert werden kann.

In den Lichtleiter kann also das von einem Leuchtelement, beispielsweise von einer Leuchtdiode, ausgesendete Licht eingekoppelt werden. Durch die Verwendung eines geeigneten diffusen Materials und/oder durch eine geeignet strukturierte Oberfläche kann das eingekoppelte Licht entlang der Längserstreckung des Lichtleiters zumindest annähernd gleichmäßig aus dem Lichtleiter ausgekoppelt werden, so dass im Ergebnis die Oberfläche des Lichtleiters aufleuchtet. Der Lichtleiter kann beispielsweise aus Polykarbonat (PC) mit Zuschlagsstoffen in einem Spritzgussverfahren hergestellt werden.

Gemäß einem weiteren Ausführungsbeispiel der Erfindung weist die Anzeigeeinrichtung eine Anordnung von mehreren Leuchtelementen auf, welche Anordnung um die Kante des Gehäuses herum geführt ist.

Die Leuchtelemente können insbesondere Leuchtdioden oder Glimmlampen sein, welche gemeinsam angesteuert werden.

Gemäß einem weiteren Ausführungsbeispiel der Erfindung weist die Anzeigeeinrichtung ein längliches Leuchtelement auf, das um die Kante des Gehäuses herum geführt ist.

Das längliche Leuchtelement kann insbesondere eine organische Leuchtdiode (OLED) sein. Organische Leuchtdioden können nämlich auf einem flexiblen Substrat hergestellt und damit einfach gebogen werden. Bei der Herstellung der beschriebenen Anzeigevorrichtung kann somit auf einfache Weise und ohne Beschädigungen besorgen zu müssen das längliche Leuchtelement um die Kante des Gehäuses herum geführt werden.

OLEDs haben gegenüber herkömmlichen aus einen kristallinen halbleitenden Material hergestellten Leuchtdioden den Vorteil, dass die Stromdichte und die Leuchtdichte geringer sind und sich OLEDs damit insbesondere für die Realisierung von relativ großflächigen Leuchtelementen eignen.

Weitere Vorteile und Merkmale der vorliegenden Erfindung ergeben sich aus der folgenden beispielhaften Beschreibung derzeit bevorzugter Ausführungsformen.
- Figur 1a: zeigt in einem zusammengesteckten Zustand einen zweipoligen Spannungsprüfer mit einem Hauptteil und einem Griffteil, wobei der Hauptteil mit einem Rundumdisplay ausgestattet ist.
- Figur 1b, c: zeigen vergrößerte perspektivische Darstellungen des in Figur 1a dargestellten Rundumdisplays.
- Figur 1d: zeigt das aus dem Gehäuse des Hauptteils entnommene Rundumdisplay.
- Figur 2: zeigt ein Multimeter, welches zusätzlich zu einer gewöhnlichen alphanumerischen Anzeige mit insgesamt vier umlaufenden Leuchtelementen ausgestattet ist, welche das Vorhandensein eines gefährlichen Spannungspegels und/oder eines elektrischen Durchgangs zwischen zwei Messpunkten anzeigen.

Es wird darauf hingewiesen, dass Merkmale bzw. Komponenten von unterschiedlichen Ausführungsformen, die mit den entsprechenden Merkmalen bzw. Komponenten der Ausführungsform nach gleich oder zumindest funktionsgleich sind, mit den gleichen Bezugszeichen oder mit einem Bezugszeichen versehen sind, welches sich von dem Bezugszeichen der gleichen oder zumindest funktionsgleichen Merkmale bzw. Komponenten lediglich in der ersten Ziffer unterscheidet. Zur Vermeidung von unnötigen Wiederholungen werden bereits anhand einer vorher beschriebenen Ausführungsform erläuterte Merkmale bzw. Komponenten an späterer Stelle nicht mehr im Detail erläutert.

Ferner wird darauf hingewiesen, dass die nachfolgend beschriebenen Ausführungsformen lediglich eine beschränkte Auswahl an möglichen Ausführungsvarianten der Erfindung darstellen. Insbesondere ist es möglich, die Merkmale einzelner Ausführungsformen in geeigneter Weise miteinander zu kombinieren, so dass für den Fachmann mit den hier explizit dargestellten Ausführungsvarianten eine Vielzahl von verschiedenen Ausführungsformen als offensichtlich offenbart anzusehen sind.

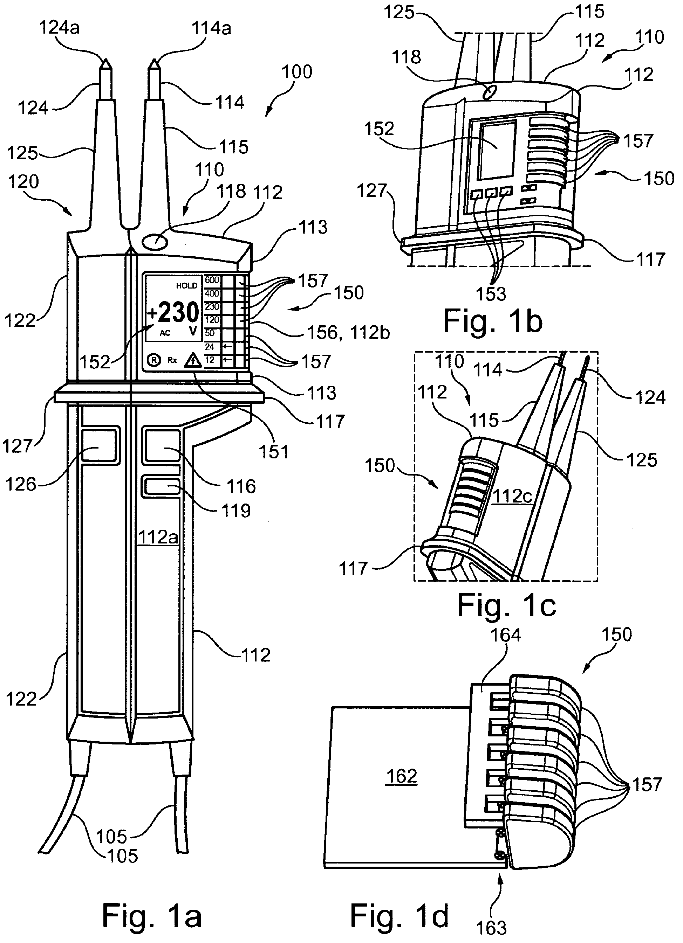

Figur 1a zeigt in einem zusammengesteckten Zustand einen zweipoligen Spannungsprüfer 100, welche ein Messgerät im Sinne der in diesem Dokument beschriebenen Erfindung darstellt. Der Spannungsprüfer 100 weist einen Hauptteil 110 und einen (daran angesteckten) Griffteil 120 auf. Hauptteil 110 und Griffteil 120 sind in bekannter Weise mittels einer elektrischen Verbindungsleitung 105 (nur teilweise dargestellt) miteinander verbunden. Mit dem zweipoligen Spannungsprüfer 100 kann das Vorhandensein und/oder die Höhe von einer zwischen zwei Messpunkten anliegenden Spannungsdifferenz erfasst werden. Ferner kann mit dem hier nachfolgend beschriebenen Spannungsprüfer 100 ein elektrischer Durchgang und/oder die Lage eine Drehfeldes detektiert werden.

Der Hauptteil 110 weist ein Hauptgehäuse 112 auf, welches bevorzugt aus einem Kunststoffmaterial gefertigt ist. Um den Hauptteil 110 vor mechanischen Beschädigungen zu schützen, sind gemäß dem hier dargestellten Ausführungsbeispiel die Kanten des Hauptgehäuses 112 mit einem weichelastischen Kunststoffmaterial geschützt. An dem vorderen Ende des Hauptgehäuses 112 (in Figur 1a oben) befindet sich eine erste Prüfelektrode 114, welche teilweise mit einer elektrischen Isolierung 115 umgeben ist. An dem vorderen Ende der Prüfelektrode 114 befindet sich frei von einer Isolierung eine Prüfspitze 114a, welche bei einem Messvorgang mit einem elektrischen Messpunkt in Kontakt gebracht wird.

Um eine sichere Handhabung des zweipoligen Spannungsprüfers 100 zu gewährleisten und um insbesondere ein Abrutschen der Hand einer Bedienperson zu vermeiden, ist an dem Hauptgehäuse 112 ein senkrecht zur Längserstreckung des Hauptteils 110 orientierter Steg 117 ausgeformt, welcher bevorzugt ebenfalls aus einem weichelastischen Kunststoffmaterial hergestellt ist. Gemäß dem hier dargestellten Ausführungsbeispiel verläuft der Steg 117 um das gesamte Hauptgehäuse 112 herum und kann deshalb auch als Abrutsch(vermeidungs)ring 117 bezeichnet werden.

In dem Hauptgehäuse 112 integriert befindet sich eine in den Figuren nicht dargestellte Messeinrichtung, welche mit einer Anzeigeeinrichtung 150 gekoppelt ist. Die Anzeigeeinrichtung ist an dem Hauptgehäuse 112 angebracht. Die Anzeigeeinrichtung weist zwei Teilbereiche auf. Ein erster Teilbereich 151 ist im Wesentlichen eben und befindet sich an einer ersten Außenseite 112a, welche in Figur 1a die Vorderseite 112a des Hauptteils 110 darstellt. Ein zweiter Teilbereich 156 erstreckt sich ausgehend von der Vorderseite 112a in gerundeter Weise um eine Kante 113 des Hauptgehäuses 112 herum bis hin in eine zweite Außenseite 112b, welche in der Darstellung von Figur 1 eine seitliche Außenseite 112b ist.

Gemäß dem hier dargestellten Ausführungsbeispiel wird der erste Teilbereich 151 u.a. dazu verwendet, gemessene Spannungswerte auf einer alphanumerischen Spannungsanzeige 152 anzuzeigen. Der zweite Teilbereich 156 der Anzeigeeinrichtung 150 wird dazu verwendet, mittels mehrerer digitaler Ja/Nein-Informationen einem Nutzer des Spannungsprüfers 100 anzuzeigen, ob ein aktuell gemessener Spannungswert einen oder mehrere Referenzspannungswerte übersteigt, wobei jedem Referenzspannungswert einen zum Aufleuchten fähigen Flächenelement 157 zugeordnet ist.

Die Flächenelemente 157 verlaufen um die Kante 113 herum, so dass sie von dem betreffenden Nutzer unter einem größeren Blickwinkelbereich beobachtet werden können als die alphanumerische Spannungsanzeige 152. Gemäß dem hier dargestellten Ausführungsbeispiel erstrecken sich die leuchtfähigen Flächenelemente 157 ausgehend von der Vorderseite 112a nicht nur bis in die seitliche Außenseite 112b sondern darüber hinaus bis in eine der Vorderseite 112a gegenüber liegende Rückseite. Gleiches gilt natürlich auch für den zweiten Teilbereich 156 der Anzeigeeinrichtung 150, in welchem sich die leuchtfähigen Flächenelemente 157 befinden. Dies bedeutet, dass jeweils zumindest ein Teil der leuchtfähigen Flächenelemente 157 praktisch von allen Raumwinkeln aus erkannt werden kann. Dadurch ist es nicht mehr erforderlich, dass in einer ungünstigen Arbeitsposition ein Nutzer des zweipoligen Spannungsprüfers 100 den Hauptteil 110 dreht, um auf bequeme Weise ein Aufleuchten der einzelnen Flächenelemente 157 erkennen zu können.

Gemäß dem hier dargestellten Ausführungsbeispiel ist die nicht dargestellte Messeinrichtung und/oder die Anzeigeeinrichtung derart konfiguriert, dass bei einem Überschreiten eines Pegels des von der Prüfelektrode erfassten Signals über einen bestimmten dieser Referenzspannungswerte nicht nur das betreffende diesem bestimmten Referenzspannungswert zugeordnete Flächenelement sondern auch diejenigen Flächenelemente aufleuchten, welche kleineren und ebenfalls überschrittenen anderen Referenzspannungswerten zugeordnet sind.

Der Hauptteil 110 weist ferner eine Lampe 118 auf, welche durch Drücken eines Tastschalters 119 angeschaltet werden kann. Dies erleichtert die Handhabung des Spannungsprüfers 100 insbesondere in dunklen Arbeitsräumen. Selbstverständlich können die Lampe 118 und/oder zumindest eine weitere Lampe auch an anderer Stelle an dem Hauptteil 110 angebracht sein.

Ferner weist der Hauptteil 110 noch einen Tastschalter 116 auf, welcher gemäß dem hier dargestellten Ausführungsbeispiel zwischen dem Taster 119 und der Anzeigeeinrichtung 150 angeordnet ist. Der Tastschalter 116 dient dazu, um kurzfristig einen relativ großen Stromfluss durch den zweipoligen Spannungsprüfer 100 zu erlauben und dabei beispielsweise das korrekte Auslösen eines Fehlerstromschutzschalters zu testen. Das Zuschalten der Last erfolgt immer über das Drücken des Tastschalters 116 und eines weiteren Tastschalters 126, welcher sich an dem Griffteil 120 befindet. Ein korrektes Auslösen eines Fehlerstromschutzschalters kann damit aus Sicherheitsgründen nur mittels einer Zweihandbedienung getestet werden.

Es wird ausdrücklich darauf hingewiesen, dass die dargestellte relative Anordnung von Anzeigeeinrichtung 150, Lampe 118 und den beiden Tastern 116 und 119 nur beispielhaft ist und dass selbstverständlich auch andere räumliche Anordnungen möglich sind.

Das Griffteil 120 weist ein Griffgehäuse 122 auf, welches bevorzugt ebenfalls aus einem Kunststoffmaterial gefertigt ist. Um das Griffteil 120 vor mechanischen Beschädigungen zu schützen, sind gemäß dem hier dargestellten Ausführungsbeispiel auch die Kanten des Griffgehäuses 122 mit einem weichelastischen Kunststoffmaterial geschützt. An dem vorderen Ende des Griffgehäuses 122 (in Figur 1a oben) befindet sich eine zweite Prüfelektrode 124, welche zum Teil mit einer elektrischen Isolierung 145 umgeben ist. An dem vorderen Ende der Prüfelektrode 124 befindet sich frei von einer Isolierung eine Prüfspitze 124a, welche bei einem Messvorgang mit einem weiteren elektrischen Messpunkt in Kontakt gebracht wird.

Um auch eine sichere Handhabung des Griffteils 120 zu gewährleisten und um insbesondere ein Abrutschen der Hand einer Bedienperson zu vermeiden, ist an dem Griffgehäuse 122 ein senkrecht zur Längserstreckung des Griffteils 120 orientierter Steg 127 ausgeformt, welcher bevorzugt ebenfalls aus einem weichelastischen Kunststoffmaterial hergestellt ist. Gemäß dem hier dargestellten Ausführungsbeispiel verläuft der Steg 127 um das gesamte Griffgehäuse 122 herum und kann deshalb ebenfalls auch als Abrutsch(vermeidungs)ring 127 bezeichnet werden.

Die Figuren 1b und 1c zeigen vergrößerte perspektivische Darstellungen der in Figur 1a dargestellten und als Rundumdisplay ausgebildeten Anzeigeeinrichtung 150. Gut zu erkennen ist, dass sich die zum Aufleuchten fähigen Flächenelemente 157 bis in eine dritte Außenseite bzw. eine Rückseite 112c des Hauptgehäuses 112 erstreckt. Somit ist offensichtlich, dass ein Nutzer ein Aufleuchten der einzelnen Flächenelemente 157 unter verschiedenen Beobachtungswinkeln, d.h. innerhalb eines sehr großen Winkelbereichs, zuverlässig erkennen kann.

Aus Figur 1b ist ersichtlich, dass sich gemäß dem hier dargestellten Ausführungsbeispiel in dem ersten Teilbereich 151 drei weitere, ebene und zum Aufleuchten fähige Flächenelemente 153 befinden, welche dem Nutzer des zweipoligen Spannungsprüfers 100 weitere (bevorzugt weniger wichtige) Messinformationen wie beispielsweise die Drehrichtung eines elektrischen Drehfeldes anzeigen können.

Figur 1d zeigt das aus dem Gehäuse des Hauptteils entnommene Rundumdisplay 150. Dem Rundumdisplay 150 ist eine Leiterplatte 162 zugeordnet, auf welchen mehrere Leuchtdioden 163 angeordnet sind. Dabei ist jeweils eine Leuchtdiode 163 einem zum Aufleuchten fähigen Flächenelement 157 zugeordnet. Die Flächenelemente 157 stellen jeweils einen Teil eines einstückigen optischen Lichtleitelements 162, welches insgesamt sechs jeweils einen Lichtleiter darstellenden Finger aufweist. Dabei wird das von jeweils einer Leuchtdiode 163 ausgesandte Licht in das hintere Ende eines Fingers (in Figur 1d nicht zu erkennen) eingekoppelt und entlang des jeweiligen Fingers nach vorne geleitet. Das optische Lichtleitelement 162 ist aus einem geeigneten optisch diffusen Material hergestellt und/oder weist eine geeignet strukturierte Oberfläche auf, so dass das eingekoppelte Licht entlang der Längserstreckung des Lichtleiters zumindest annähernd gleichmäßig aus dem Lichtleiter ausgekoppelt wird. Im Ergebnis leuchtet dann die Oberfläche des lichtleitenden Fingers auf. Das optische Lichtleitelement 162 kann beispielsweise aus Polykarbonat (PC) mit Zuschlagsstoffen mittels eines Spritzgussverfahrens hergestellt werden.

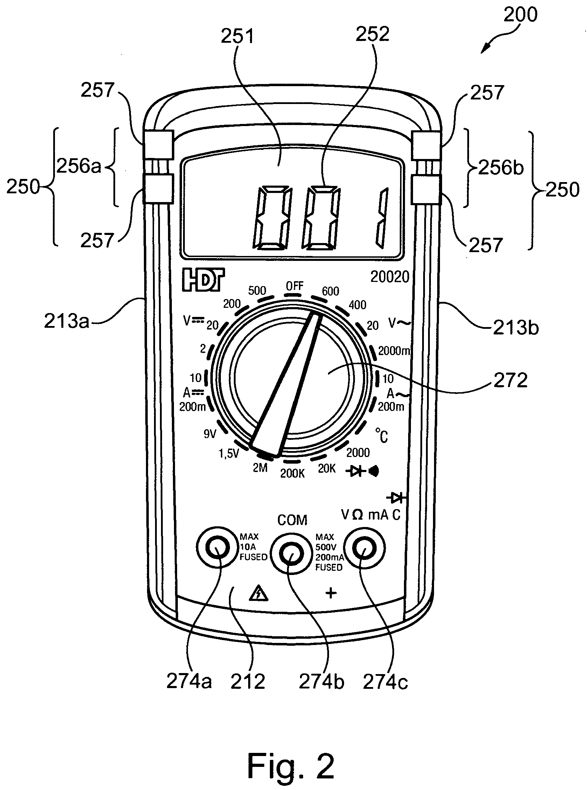

Figur 2 zeigt ein Multimeter 200, welches ebenfalls mit einer als Rundumdisplay ausgebildeten Anzeigeeirichtung 250 ausgestattet ist. Das Rundumdisplay 250 weist zusätzlich zu einem gewöhnlichen ersten Teilbereich 251 mit einer alphanumerischen Anzeige 252 zwei zweite Teilbereiche 256a und 256b auf, welche sich um jeweils eine seitliche Kante 213a bzw. 213b eines Gehäuses 212 des Multimeters 200 erstrecken bzw. um jeweils eine seitliche Kante 213a bzw. 213b eines Gehäuses 212 herum geführt sind. Die Teilbereiche 256a und 256b weisen jeweils zwei zum Aufleuchten fähige Flächenelemente 257 auf, welche sich wie der jeweilige Teilbereich 256a bzw. 256b um die Kanten 213a bzw. 213b des Gehäuses 212 herum erstrecken. Gemäß dem hier dargestellten Ausführungsbeispiel erstrecken sich die Flächenelemente 257 nicht nur um die beiden oberen Kanten 213a bzw. 213b sondern auch um jeweils eine untere Kante (nicht dargestellt) des Gehäuses 212 herum. Dies bedeutet, dass zumindest ein Teil der Flächenelemente 257 auch bei einer Betrachtung des Messgerätes 200 von hinten erkannt werden kann.

Das Multimeter 200 kann beispielsweise derart konfiguriert sein, dass ab einem Überschreiten eines ersten bestimmten vorgegebenen Referenzspannungsniveaus, bei dem für einen Nutzer potentiell die Gefahr eines Stromschlags besteht, die beiden unteren der insgesamt vier Flächenelemente 257 aufleuchten. Ferner können bei einem Überschreiten eines im Vergleich zum ersten Referenzspannungsniveau höheren vorgegebenen zweiten Referenzspannungsniveaus zusätzlich die beiden oberen der insgesamt vier Flächenelemente 257 aufleuchten. Auf diese Weise kann ein Nutzer zuverlässig und unabhängig von der Orientierung des Multimeters 200 zu seiner Blickrichtung vor einer potentiellen Gefahr eines Stromschlages gewarnt werden.

Die Flächenelement 257 können beispielsweise mittels eines mit jeweils einer Leuchtdiode optisch gekoppelten Lichtleiters (vgl. Ausführungsbeispiel in Figur 1d), mittels mehrerer in einer Reihe angeordneten Leuchtdioden oder mittels einer länglichen biegbaren Leuchtdiode, beispielsweise einer OLED, realisiert werden.

Die übrigen in Figur 2 dargestellten Komponenten des Multimeters 200 wie beispielsweise ein Drehschalter 272 und Anschlusskontakte 274a, 274b und 274c für Messkabel sind gleich wie bei einem herkömmlichen Multimeter und werden deshalb an dieser Stelle nicht erläutert.

### BEZUGSZEICHEN:

- 100: Zweipoliger Spannungsprüfer
- 105: elektrische Verbindungsleitung
- 110: Hauptteil
- 112: Hauptgehäuse
- 112a: erste Außenseite / Vorderseite
- 112b: zweite Außenseite /seitliche Außenseite
- 112c: dritte Außenseite / Rückseite
- 113: Kante
- 114: erste Prüfelektrode
- 114a: Prüfspitze
- 115: Isolierung
- 117: Steg (Abrutschring)
- 118: Lampe
- 119: Tastschalter für Lampe
- 120: Griffteil
- 122: Griffgehäuse
- 124: zweite Prüfelektrode
- 124a: Prüfspitze
- 125: Isolierung
- 126: Tastschalter für Auslösung Fehlerstromschutzschalter
- 127: Steg (Abrutschring)
- 150: Anzeigeeinrichtung / Rundumdisplay
- 151: erster Teilbereich
- 152: alphanumerische Spannungsanzeige
- 153: ebene Flächenelemente
- 156: zweiter Teilbereich
- 157: zum Aufleuchten fähige Flächenelemente
- 162: Leiterplatte
- 163: Leuchtdioden
- 164: Lichtleitelement
- 200: Multimeter
- 212: Gehäuse
- 213a/b: Kante
- 250: Anzeigeeinrichtung / Rundumdisplay
- 251: erster Teilbereich
- 252: alphanumerische Anzeige
- 256a/b: zweiter Teilbereich
- 257: zum Aufleuchten fähige Flächenelemente
- 272: Drehschalter
- 274a/b/c: Anschlusskontakte

## Patentansprüche

1. Messgerät zum Erfassen und Anzeigen von elektrischen Größen, insbesondere zum Erfassen und Anzeigen von Spannungs-, Strom- und/oder Widerstandswerten, das Messgerät (100, 200) aufweisend
ein Gehäuse (112, 212),
eine Messeinrichtung, welche in dem Gehäuse (112, 212) angeordnet ist,
zumindest eine Prüfelektrode (114) und/oder zumindest einen Anschluss (274c) für zumindest eine Prüfelektrode, welche bzw. welcher elektrisch leitend mit der Messeinrichtung verbunden ist,
eine Anzeigeeinrichtung (150, 250), welche an dem Gehäuse (112, 212) angebracht ist und welche mit der Messeinrichtung gekoppelt ist, so dass eine von der Messeinrichtung erlangte Messinformation anzeigbar ist, **dadurch gekennzeichnet dass**
sich die Anzeigeeinrichtung (150, 250) über eine Kante (113, 213a, 213b) des Gehäuses (212) erstreckt, so dass die Anzeigeeinrichtung (150, 250) sowohl zumindest einen ersten Teil einer ersten Außenseite (112a) des Gehäuses (112, 212) als auch zumindest einen zweiten Teil einer zweiten Außenseite (112b) des Gehäuses (112, 212) bedeckt, wobei die erste Außenseite (112a) und die zweite Außenseite (112b) winklig, insbesondere senkrecht, zueinander orientiert sind.

2. Messgerät gemäß dem vorangehenden Anspruch, wobei die Anzeigeeinrichtung (150, 250) konfiguriert ist zumindest eine erste Messinformation in einem ersten Teilbereich (151, 251) der Anzeigeeinrichtung (150, 250) und zumindest eine zweite Messinformation in einem zweiten Teilbereich (156, 256a, 256b) der Anzeigeeinrichtung (150, 250)anzuzeigen, wobei
sich der erste Teilbereich (151, 251) an lediglich einer (112a) der beiden Außenseiten (112a, 112b) befindet und
sich der zweite Teilbereich (156, 256a, 256b) von der ersten Außenseite (112a) über die Kante (113, 213a, 213b) des Gehäuses (112, 212) in die zweite Außenseite (112b) erstreckt.

3. Messgerät gemäß dem vorangehenden Anspruch, wobei die zweite Messinformation eine digitale Ja/Nein-Information über eine vorgegebene elektrische Eigenschaft des von der zumindest einen Prüfelektrode (114) erfassten Signals aufweist.

4. Messgerät gemäß dem vorangehenden Anspruch, wobei die zweite Messinformation zusätzlich zumindest eine weitere digitale Ja/Nein-Information über eine vorgegebene weitere elektrische Eigenschaft des von der zumindest einen Prüfelektrode (114) erfassten Signals aufweist.

5. Messgerät gemäß einem der vorangehenden Ansprüche 2 bis 4, wobei die erste Messinformation eine quantitative Information über das von der zumindest einen Prüfelektrode (114) erfasste Signal ist.

6. Messgerät gemäß einem der vorangehenden Ansprüche, wobei sich die Anzeigeeinrichtung (150, 250) über zumindest eine weitere Kante des Gehäuses (112, 212) erstreckt, so dass die Anzeigeeinrichtung (150, 250) zusätzlich einen dritten Teil einer dritten Außenseite (112c) des Gehäuses (112, 212) bedeckt, wobei die zweite Außenseite (112b) und die dritte Außenseite (112c) winklig, insbesondere senkrecht, zueinander orientiert sind.

7. Messgerät gemäß einem der vorangehenden Ansprüche 1 bis 6, wobei die Anzeigeeinrichtung (150, 250) einen Lichtleiter (164) aufweist, der um die Kante (113, 213a, 213b) des Gehäuses (112, 212) herum geführt ist.

8. Messgerät gemäß einem der vorangehenden Ansprüche 1 bis 6, wobei die Anzeigeeinrichtung (150, 250) eine Anordnung von mehreren Leuchtelementen (157, 257) aufweist, welche Anordnung um die Kante (113, 213a, 213b) des Gehäuses (112, 212) herum geführt ist.

9. Messgerät gemäß einem der vorangehenden Ansprüche 1 bis 6, wobei die Anzeigeeinrichtung (150, 250) ein längliches Leuchtelement aufweist, das um die Kante (113, 213a, 213b) des Gehäuses (112, 212) herum geführt ist.

## Claims

1. Measuring device for detecting and displaying electric variables, in particular for detecting and displaying voltage, current and/or resistance values, the measuring device (100, 200) comprising
a housing (112, 212),
a measuring unit, which is disposed in the housing (112, 212),
at least one testing electrode (114) and/or at least one terminal (274c) for at least one testing electrode, which testing electrode or terminal is connected in an electrically conductive manner to the measuring unit,
a display device (150, 250), which is attached to the housing (112, 212) and which is coupled to the measuring unit so that an item of measurement information obtained from the measuring unit can be displayed,
**characterised in that** the display device (150, 250) extends over an edge (113, 213a, 213b) of the housing (212) so that the display device (150, 250) covers both at least a first part of a first outer side (112a) of the housing (112, 212) and also at least a second part of a second outer side (112b) of the housing (112, 212), wherein the first outer side (112a) and the second outer side (112b) are oriented at an angle, in particular perpendicular, to one another.

2. Measuring device as claimed in the preceding claim, wherein the display device (150, 250) is configured to display at least a first item of measurement information in a first partial region (151, 251) of the display device (150, 250) and at least a second item of measurement information in a second partial region (156, 256a, 256b) of the display device (150, 250), wherein
the first partial region (151, 251) is located at only one (112a) of the two outer sides (112a, 112b) and
the second partial region (156, 256a, 256b) extends from the first outer side (112a) over the edge (113,213a, 213b) of the housing (112, 212) into the second outer side (112b).

3. Measuring device as claimed in the preceding claim, wherein the second item of measurement information comprises an item of digital yes/no information relating to a preset electrical property of the signal detected by the at least one testing electrode (114).

4. Measuring device as claimed in the preceding claim, wherein the second item of measurement information additionally comprises at least one further item of digital yes/no information relating to a preset further electrical property of the signal detected by the at least one testing electrode (114).

5. Measuring device as claimed in any one of the preceding claims 2 to 4, wherein the first item of measurement information is quantitative information relating to the signal detected by the at least one testing electrode (114).

6. Measuring device as claimed in any one of the preceding claims, wherein the display device (150, 250) extends over at least one further edge of the housing (112, 212) so that the display device (150, 250) additionally covers a third part of the third outer side (112c) of the housing (112, 212), wherein the second outer side (112b) and the third outer side (112c) are oriented at an angle, in particular perpendicular, to one another.

7. Measuring device as claimed in any one of the preceding claims 1 to 6, wherein the display device (150, 250) comprises a light conductor (164) which is guided around the edge (113, 213a, 213b) of the housing (112, 212).

8. Measuring device as claimed in any one of the preceding claims 1 to 6, wherein the display device (150, 250) comprises an arrangement of a plurality of illuminating elements (157, 257), which arrangement is guided around the edge (113, 213a, 213b) of the housing (112,212).

9. Measuring device as claimed in any one of the preceding claims 1 to 6, wherein the display device (150, 250) comprises an elongate illuminating element which is guided around the edge (113, 213a, 213b) of the housing (112, 212).

## Revendications

1. Instrument de mesure pour détecter et afficher des grandeurs électriques, en particulier pour détecter et afficher des valeurs de tension, de courant et/ou de résistance, l'instrument de mesure (100, 200) présentant un boîtier (112, 212),
un système de mesure qui est agencé dans le boîtier (112, 212),
au moins une électrode de contrôle (114) et/ou au moins un raccord (274c) pour au moins une électrode de contrôle qui est relié(e) de façon électriquement conductrice au système de mesure,
un système d'affichage (150, 250) qui est monté sur le boîtier (112, 212) et qui est couplé au système de mesure, de telle manière qu'une information de mesure reçue du système de mesure puisse être affichée,
**caractérisé en ce que** le système d'affichage (150, 250) recouvre un bord (113, 213a, 213b) du boîtier (212), de telle manière que le système d'affichage (150, 250) recouvre aussi bien au moins une première partie d'un premier côté extérieur (112a) du boîtier (112, 212) qu'au moins une deuxième partie d'un deuxième côté extérieur (112b) du boîtier (112, 212), dans lequel le premier côté extérieur (112a) et le deuxième côté extérieur (112b) sont orientés sous un angle, en particulier perpendiculairement, l'un par rapport à l'autre.

2. Instrument de mesure selon la revendication précédente, dans lequel le système d'affichage (150, 250) est configuré pour afficher au moins une première information de mesure dans une première zone partielle (151, 251) du système d'affichage (150, 250) et au moins une deuxième information de mesure dans une deuxième zone partielle (156, 256a, 256b) du système d'affichage (150, 250), dans lequel la première zone partielle (151, 251) se trouve uniquement sur un (112a) des deux côtés extérieurs (112a, 112b) et la deuxième zone partielle (156, 256a, 256b) s'étend du premier côté extérieur (112a) sur le bord (113, 213a, 213b) du boîtier (112, 212) dans le deuxième côté extérieur (112b).

3. Instrument de mesure selon la revendication précédente, dans lequel la deuxième information de mesure présente une information numérique Oui/Non au sujet d'une propriété électrique prédéterminée du signal détecté par ladite au moins une électrode de contrôle (114).

4. Instrument de mesure selon la revendication précédente, dans lequel la deuxième information de mesure contient en outre au moins une autre information numérique Oui/Non au sujet d'une autre propriété électrique prédéterminée du signal détecté par ladite au moins une électrode de contrôle (114).

5. Instrument de mesure selon l'une quelconque des revendications 2 à 4, dans lequel la première information de mesure est une information quantitative au sujet du signal détecté par ladite au moins une électrode de contrôle (114).

6. Instrument de mesure selon l'une quelconque des revendications précédentes, dans lequel le système d'affichage (150, 250) s'étend sur au moins un autre côté du boîtier (112, 212), de telle manière que le système d'affichage (150, 250) recouvre en plus une troisième partie d'un troisième côté extérieur (112c) du boîtier (112, 212), dans lequel le deuxième côté extérieur (112b) et le troisième côté extérieur (112c) sont orientés sous un angle, en particulier perpendiculairement l'un par rapport à l'autre.

7. Instrument de mesure selon l'une quelconque des revendications précédentes 1 à 6, dans lequel le système d'affichage (150, 250) présente un guide de lumière (164) qui est mené autour du bord (113, 213a, 213b) du boîtier (112, 212).

8. Instrument de mesure selon l'une quelconque des revendications précédentes 1 à 6, dans lequel le système d'affichage (150, 250) présente un arrangement de plusieurs éléments lumineux (157, 257), arrangement qui est mené autour du bord (113, 213a, 213b) du boîtier (112, 212).

9. Instrument de mesure selon l'une quelconque des revendications précédentes 1 à 6, dans lequel le système d'affichage (150, 250) présente un élément lumineux oblong qui est mené autour du bord (113, 213a, 213b) du boîtier (112, 212).
